(19) Europäisches Patentamt
European Patent Office
Office européen des brevets

(11) **EP 3 185 109 B1**

## (12) FASCICULE DE BREVET EUROPEEN

(45) Date de publication et mention
de la délivrance du brevet:
**31.10.2018 Bulletin 2018/44**

(51) Int Cl.:
***G06F 3/041*** *(2006.01)*      ***G06F 3/044*** *(2006.01)*
*G01R 27/26* *(2006.01)*

(21) Numéro de dépôt: **17156280.4**

(22) Date de dépôt: **08.03.2013**

(54) **PROCEDE DE MESURE CAPACITIVE ENTRE UN OBJET ET UN PLAN D'ELECTRODES PAR DEMODULATION SYNCHRONE PARTIELLE**

KAPAZITIVES MESSVERFAHREN ZWISCHEN EINEM OBJEKT UND EINER ELEKTRODENEBENE DURCH TEILWEISE SYNCHRONE DEMODULATION

METHOD OF CAPACITIVE MEASUREMENT BETWEEN AN OBJECT AND AN ELECTRODE PLANE BY PARTIAL SYNCHRONOUS DEMODULATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.03.2012 FR 1252272**

(43) Date de publication de la demande:
**28.06.2017 Bulletin 2017/26**

(62) Numéro(s) de document de la (des) demande(s) initiale(s) en application de l'article 76 CBE:
**13714870.6 / 2 825 940**

(73) Titulaire: **QuickStep Technologies LLC Wilmington, DE 19801 (US)**

(72) Inventeurs:
• **NEEL, Christian**
  **30900 Nimes (FR)**
• **BLONDIN, Christophe**
  **30900 Nîmes (FR)**

(74) Mandataire: **Lang, Johannes**
  **Bardehle Pagenberg Partnerschaft mbB**
  **Patentanwälte, Rechtsanwälte**
  **Prinzregentenplatz 7**
  **81675 München (DE)**

(56) Documents cités:
EP-A1- 0 589 498      US-A- 3 761 805
US-A- 4 634 964      US-A- 5 651 044
US-A1- 2011 163 992

**Description**

La présente invention se rapporte à un procédé de mesure capacitive entre un objet et un plan d'électrodes. Elle s'applique notamment dans le domaine général des surfaces tactiles capacitives 2D et détection capacitive 3D utilisées pour les commandes d'interface homme machine.

De plus en plus d'appareils de communication et de travail utilisent une interface de commande tactile comme un pad ou un écran. On peut citer par exemple les téléphones mobiles, Smartphones, notebooks électroniques, PC, souris, dalles, écrans géants.....

Un grand nombre de ces interfaces utilisent les technologies capacitives. La surface tactile est équipée d'électrodes conductrices reliée à des moyens électroniques permettant de mesurer la valeur des capacités crées entre des électrodes et l'objet à détecter pour effectuer une commande.

Les techniques capacitives actuelles, utilisent le plus souvent deux couches d'électrodes conductrices en forme de ligne et de colonnes. L'électronique mesure les capacités de couplage qui existent entre ces lignes et colonnes. Lorsqu'un doigt est très proche de la surface active, les capacités de couplage à proximité du doigt sont modifiées et l'électronique peut ainsi localiser la position 2D (XY) dans le plan de la surface active.

Cette technologie permet de détecter la présence et la position du doigt au travers d'un diélectrique. Cette technique a l'avantage d'obtenir une très bonne résolution sur la localisation dans le plan XY de la surface sensible d'un ou de plusieurs doigts. Ces techniques ont toutefois l'inconvénient de ne détecter qu'un contact de l'objet voire une détection très proche mais ne dépassant pas quelques mm. Il est difficile d'effectuer des commandes tactiles avec des gants épais (gant de ski, motard...), avec des ongles longs ou un stylet. La faible sensibilité des électrodes capacitives ne permet pas de déclencher une commande au travers d'un diélectrique épais.

Il existe aussi des techniques plus récentes permettant de mesurer la capacité absolue créée entre les électrodes et l'objet à détecter. Cette technique est similaire aux techniques dites self capacitance. On peut citer par exemple le brevet FR2756048 : Pont de mesure capacitif flottant, le brevet FR2893711 : Dispositif et procédé de mesure capacitive par pont flottant ou le brevet FR2844349 : Détecteur capacitif de proximité. Ces techniques permettent d'obtenir une mesure de la capacité inter électrode-objet de très haute résolution et de détecter par exemple un doigt à plusieurs cm voire à 10cm de distance. La détection se fait dans l'espace en 3 dimensions XYZ mais aussi en tactile sur le plan XY. On peut cette fois déclencher une commande avec un gant ou au travers de tout type de diélectrique épais.

Ces techniques récentes impliquent de placer derrière les électrodes de mesure un plan conducteur uniforme, porté au potentiel d'excitation des électrodes en regard de la masse du système, éventuellement transparent optiquement qui élimine les capacités de couplage parasite entre la masse du système et les électrodes.

Les techniques de mesures capacitives classiques utilisent une fréquence porteuse, de préférence de forme sinusoïdale, et un système de démodulation synchrone pour mesurer la capacité. Lorsque la nature du capteur est purement capacitive, le signal mesuré correspondant à la capacité inter électrode-objet est en phase avec la porteuse. En pratique, la surface tactile est de nature légèrement résistive à cause de la résistivité du matériau utilisé par exemple ITO pour les surfaces tactiles transparentes. Cette nature résistive du capteur crée un déphasage qui est vu par l'électronique comme une fuite résistive (en quadrature avec la porteuse) et qui peut créer une erreur significative sur la mesure. A la sortie du système de mesure par démodulation synchrone, un signal d'erreur en quadrature apparaît proportionnel à la fuite résistive du capteur. Ce signal vient dégrader la mesure de la capacité inter électrode-objet.

US 5,651,044 décrit un détecteur de proximité capacitif.

US 4,634,964 décrit un système de mesure de la capacité d'un conducteur de signal électrique.

US 3,761,805 décrit un procédé et un système de mesure de capacité utilisant une technique à charge de courant constant.

La présente invention a pour but de palier les inconvénients de l'art antérieur en proposant un nouveau procédé pour écarter cette erreur en quadrature.

On atteint l'objectif précité avec un procédé de mesure capacitive entre un objet et un plan d'électrodes, dans lequel procédé on utilise une unité de traitement pour :

-  appliquer un signal d'excitation au plan d'électrodes résistif, et
-  détermine une valeur de capacité à partir d'une mesure d'un signal de mesure provenant du plan d'électrodes

L'invention s'applique avantageusement aux les électrodes conçues à partir d'un matériau résistif. A titre d'exemple, les électrodes et le plan conducteur sont conçues à partir de l'oxyde d'indium dopé à l'étain (ITO). D'autres matériaux transparents à la lumière comme l'oxyde de zinc dopé de l'aluminium (AZO) ou de l'oxyde de cadmium dopé à l'étain peuvent aussi être utilisés.

Selon l'invention, le signal d'excitation est un signal non sinusoïdal comprenant au moins une discontinuité. Pour déterminer la valeur de capacité, on atténue sur une fenêtre temporelle le signal de mesure, cette fenêtre temporelle étant la durée pendant laquelle la résistivité du plan d'électrode se manifeste sur le signal de mesure en réponse à ladite au moins une discontinuité. Par discontinuité, on entend par exemple de façon non limitative un front de durée inférieure à un dixième de la période du signal. Une discontinuité peut également être définie comme tout élément de signal d'excitation provoquant une composante en quadrature de phase par rapport au signal d'excitation.

Avec le procédé selon l'invention, des moyens d'excitation tels un générateur de signaux, génèrent une forme d'onde non sinusoïdale, puis on identifie la zone perturbée dans le signal de mesure et on atténue cette perturbation lors de la détermination de la capacité. En d'autres termes, on applique un signal susceptible de décorréler les effets résistifs des effets capacitifs sur le signal de mesure ; cette perturbation générant une composante en quadrature de phase avec le signal d'excitation et donc le signal utile. Ainsi, il est ensuite possible de s'affranchir des influences des effets de la résistivité des électrodes sur la mesure capacitive.

Lorsque la composante en quadrature est atténuée, il reste la composante en phase qui permet de déterminer la valeur de capacité en réalisant une démodulation synchrone. De préférence, le signal de mesure est supprimé sur ladite fenêtre temporelle. On parle alors de démodulation partielle puisque seule une partie du signal de mesure est démodulée.

Selon une caractéristique avantageuse de l'invention, le signal d'excitation est un signal carré ou rectangulaire. Avec un tel signal, la présente invention propose une méthode pour s'affranchir du signal en quadrature. En effet, lorsque la source est un signal carré cette quadrature se manifeste par un pic à chaque front de la porteuse. Pour s'affranchir de ce pic parasite, on réalise donc une démodulation partielle du signal de mesure, c'est-à-dire en laissant « passer » le pic avant de démoduler le signal.

Selon une autre caractéristique avantageuse de l'invention, on applique également le signal d'excitation sur un plan conducteur utilisé comme plan de garde active contre des fuites capacitives.

De façon générale, un plan de garde active présente également une certaine résistivité s'il est conçu à partir de l'oxyde d'indium dopé à l'étain (ITO) ou autre matériau conducteur non métallique. On montre aisément que le couplage d'un tel plan de garde porté au potentiel d'excitation avec la masse du système provoque une chute de tension dont la valeur est fonction de la position (x, y) dans le plan de garde. Ainsi cette chute de tension se couple directement avec les électrodes en regard du plan, de façon diverse selon la position de l'électrode dans le plan. En cas d'excitation sinusoïdale, cela s'ajoute à la composante en quadrature de la mesure. Dans la mesure où les tensions couplées dans le plan de garde ne se produisent majoritairement également qu'à l'instant d'application de la transition discontinue du signal d'excitation, la démodulation partielle du signal de mesure permet donc d'annuler cette perturbation.

Selon un autre aspect de l'invention, il est proposé un appareil électronique comprenant :

- un écran d'affichage associé à un dispositif de détection capacitive, ce dispositif de détection capacitive comprenant un plan d'électrodes,
- une unité de traitement pour détecter la position d'un objet par rapport à l'écran d'affichage par mesure de la capacité entre ledit objet et le plan d'électrodes. Selon l'invention, l'unité de traitement est configurée pour réaliser les étapes décrites ci-dessus.

On peut utiliser un démodulateur synchrone pour déterminer la valeur de capacité.

D'autres avantages et caractéristiques de l'invention apparaîtront à l'examen de la description détaillée d'un mode de mise en oeuvre nullement limitatif, et des dessins annexés, sur lesquels :

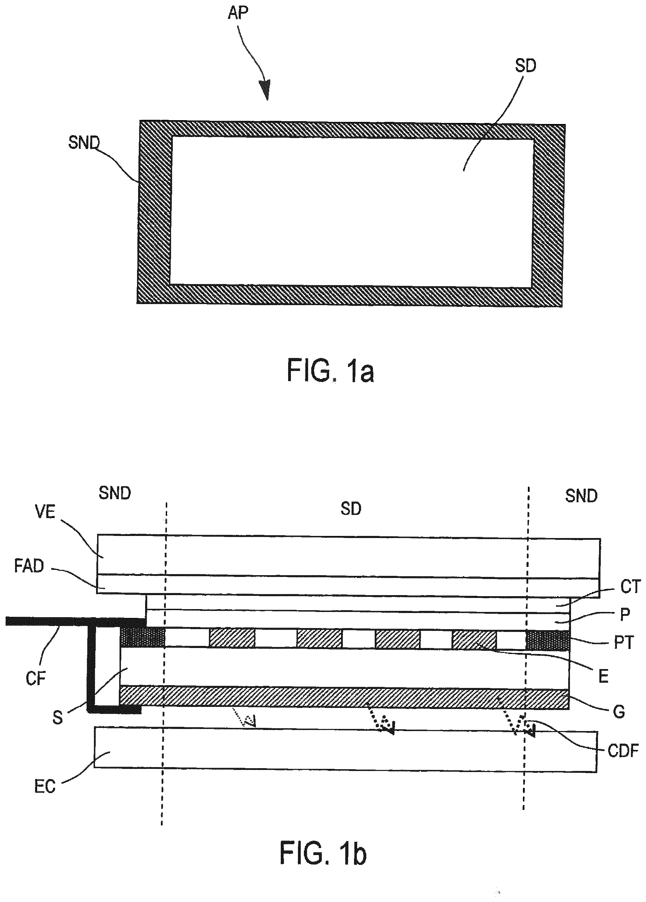

- les figures 1a et 1b sont des vues schématiques d'un appareil selon l'invention ;
- la figure 2 est une vue schématique illustrant des charges capacitives de fuite dues au caractère résistif des électrodes et de la garde ;
- les figures 3a, 3b et 3c sont des vues de schémas électroniques équivalents des électrodes et de la garde,
- la figure 4 est illustre deux graphiques illustrant l'erreur de capacité due aux résistances équivalentes dans les électrodes ;
- les figures 5a et 5b illustrent respectivement le schéma équivalent de la figure 3 avec une alimentation en tension discontinue, et un graphique illustrant les courbes des différents courants et tensions dans ce schéma équivalent ;
- la figure 6 est une vue d'un schéma électronique équivalent pour la mise en oeuvre du procédé selon l'invention.

De façon générale, sur les figures la et 1b, on voit un appareil AP selon l'invention. Il peut s'agir d'un téléphone de type « smartphone » ou d'une tablette numérique dotée d'un écran tactile. Cet appareil AP comprend une surface de détection SD qui est la partie tactile sous laquelle se trouve notamment un plan (plat ou courbé) d'électrodes. Cette surface de détection SD comprend depuis la partie supérieure, plusieurs couches en matériau transparent telles que par exemple :

- une vitre externe VE,
- un film anti-débris FAD,

- une colle transparente CT, et
- un polariseur P,
- des électrodes E en matériau transparent conducteur tel que l'oxyde d'indium dopé à l'étain (ITO),
- un support S en verre pour électrodes,
- une garde G qui est une couche en matériau transparent conducteur tel que l'oxyde d'indium dopé à l'étain (ITO), et
- un écran EC d'affichage qui doit être visible de l'extérieur depuis la vitre externe VE.

Les électrodes et la garde se trouvent donc sous la surface de détection et sont en matériau transparent conducteur qui présente une haute résistivité.

On distingue également une surface de non détection SND qui entoure dans le cas d'espèce la surface de détection SD. Cette surface est généralement opaque de l'extérieur et ne comporte pas d'électrodes mais des pistes de connexion PT et des connecteurs flexibles CF qui sont métalliques donc de résistivité quasiment nulle.

La grande résistivité du matériau transparent conducteur peut être problématique (en présence ou non de la garde G) car un couplage entre ce matériau résistif et l'écran qui est généralement à la masse de l'appareil peut avoir lieu. Les électrodes (et la garde) doivent être à sensiblement un même potentiel (différent de celui de l'écran) sur tout le plan (plan des électrodes et/ou plan de la garde). Lorsque le couplage existe avec l'écran, des courants de fuite CDF existent et sont de plus en plus intenses en s'éloignant des connexions métalliques (PT, CF). Ainsi le couplage entre le matériau transparent conducteur (électrodes et/ou garde) et l'écran devient très supérieur au couplage que l'on cherche à mesurer entre les électrodes et l'objet d'intérêt qui serait au dessus de la vitre externe.

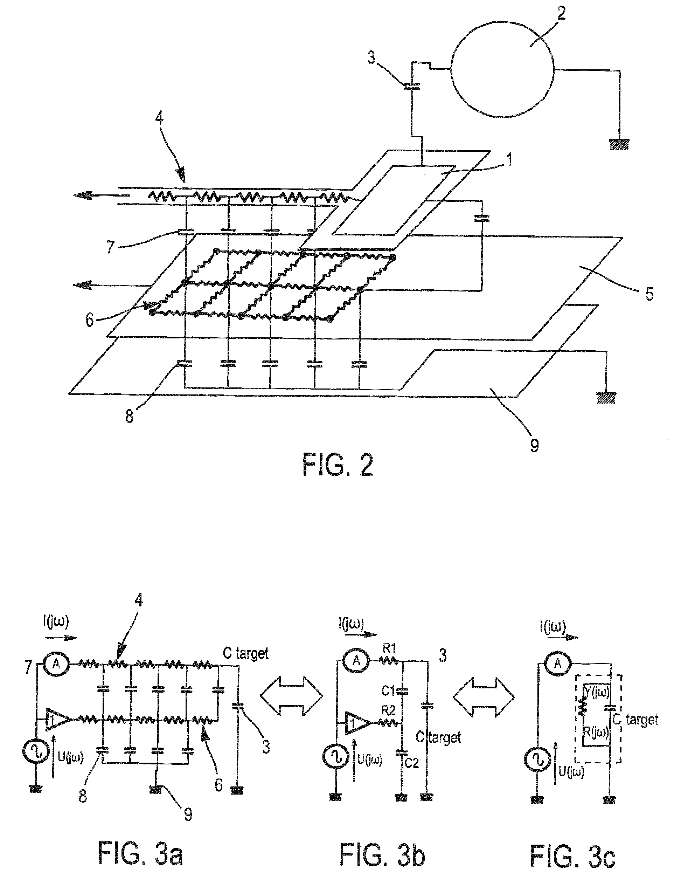

Sur la figure 2 on voit un schéma illustrant les capacités de fuite. On distingue le plan d'électrode 1 pour détecter le positionnement d'un objet 2 par mesure de la capacité 3 (Ctarget) entre eux. On estime que l'objet 2 est à la masse. Les électrodes sont conçues à base d'ITO qui présente une grande résistivité. Cette dernière est représentée par une série de résistances 4.

Le plan de garde 5 est également résistif car contient de l'ITO. Cette résistivité est représentée par un réseau de résistances 6. Des charges de fuite 7 existent entre les résistances 4 et les résistances 6. Par ailleurs, des capacités de fuite 8 existent également entre les résistances 6 et un plan de masse 9 (généralement l'écran d'affichage de l'appareil).

La figure 3a illustre un schéma électronique simplifié équivalent de la capacité 3 entre l'objet et les électrodes, les résistances 4, les capacités de fuite 7, les résistances 6, et les capacités de fuite 8. On distingue également une source de tension $U(j\omega)$ pour alimenter les résistances 4 via un courant $I(j\omega)$. La figure 3b est un schéma équivalent du schéma de la figure 3a. Les résistances 4 sont équivalentes à une résistance unique R1 en parallèle de la capacité 3 et d'une branche comprenant une capacité C1 équivalente aux capacités 7. Sur cette branche on distingue également en parallèle la résistance R2 équivalente aux résistances 6 alimentés par la tension $U(j\omega)$, et une capacité C2 équivalente des capacités 8 reliées ensuite à la masse.

La figure 3c illustre encore de manière plus simplifiée un schéma équivalent où les résistances et les capacités sont représentées par une admittance $Y(j\omega)$.

A partir de $Y(j\omega)$, la capacité équivalente $C(j\omega)$ est donnée par :

$$C(j\omega) = \frac{(C_{target} + (C_2\, C_{target} + C_1\,(C_2 + C_{target}))\, R_2\,(C_2\, R_2 + C_1\,(R_1 + R_2))\, \omega^2)}{1 + ((C_1 + C_{target})^2\, R_1^{\,2} + 2\, C_1^{\,2}\, R_1\, R_2 + (C_1 + C_2)^2\, R_2^{\,2})\, \omega^2 + (C_2\, C_{target} + C_1\,(C_2 + C_{target}))^2\, R_1^{\,2}\, R_2^{\,2}\, \omega^4}$$

$$C(j\omega) \approx C_{target} + \frac{C_1\, C_2\, R_2\,(C_2\, R_2 + C_1\, R_1 + C_1\, R_2)\, \omega^2)}{1 + C_1^{\,2}\, R_1^{\,2} + 2\, C_1^{\,2}\, R_1\, R_2 + (C_1 + C_2)^2\, R_2^{\,2})\, \omega^2 + C_1^{\,2}\, C_2^{2}\, R_1^{\,2}\, R_2^{\,2}\, \omega^4}$$

A partir de $Y(j\omega)$, la résistance équivalente $R(j\omega)$ est donnée par :

$$\frac{1}{R(j\omega)} = \frac{\omega^2\,(C_1\, C_{target}\, R_1 + C_{target}^{\,2}\, R_1 - C_1\, C_2\, R_2 + (C_2\, C_{target} + C_1\,(C_2 + C_x))^2\, R_1\, R_2^{\,2}\, \omega^2)}{1 + ((C_1 + C_{target})^2\, R_1^{\,2} + 2\, C_1^{\,2}\, R_1\, R_2 + (C_1 + C_2)^2\, R_2^{\,2})\, \omega^2 + (C_2\, C_{target} + C_1\,(C_2 + C_{target}))^2\, R_1^{\,2}\, R_2^{\,2}\, \omega^4}$$

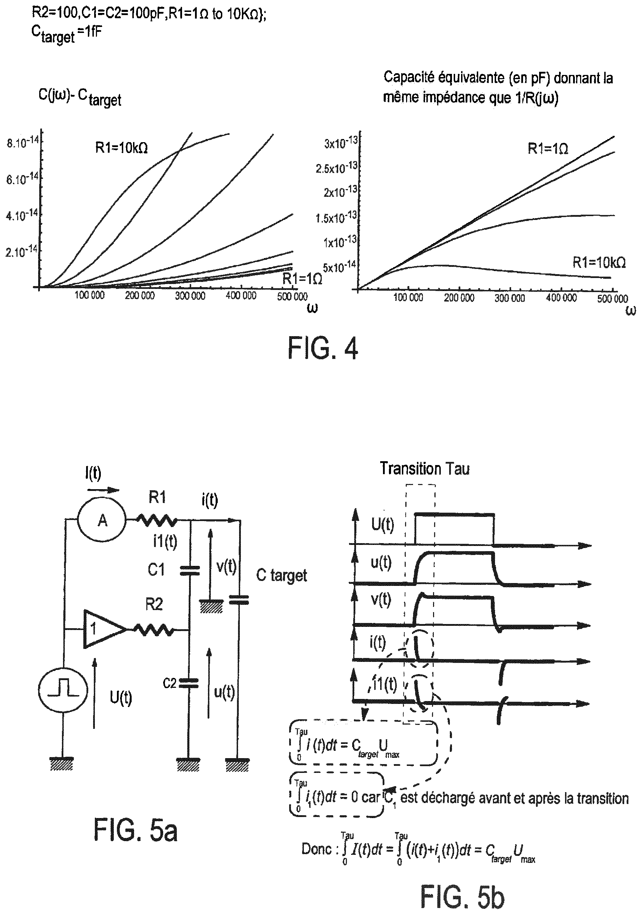

Sur la figure 4, on voit les erreurs de capacité en fonction de la fréquence.

La figure 5a illustre le schéma équivalent de la figure 3 mais avec une alimentation en tension discontinue. Il s'agit d'un créneau $U(t)$. Sur la figure 5b on voit que les signaux (courant et tension) aux bornes des capacités 3, C1 et C2 comportent une déformation au moment de la transition : front montant et front descendant. On peut définir une fenêtre temporelle ou une durée tau ($\tau$) dans laquelle se trouve cette déformation.

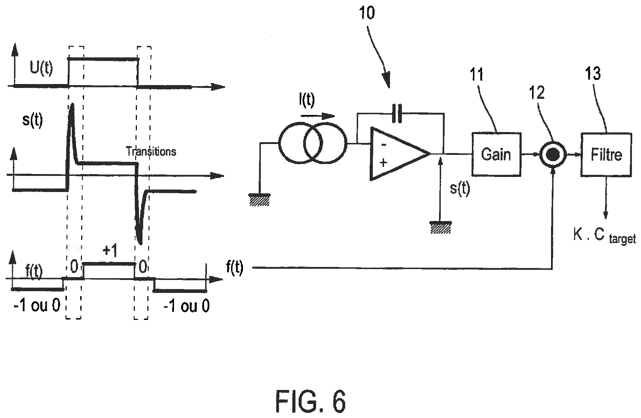

Le schéma de la figure 6 permet de ne pas prendre en compte les effets de cette discontinuité. Pour ce faire, on mesure le courant I(t) alimentant la résistance équivalente R1. Pour la mesure, ce courant est répliqué à l'entrée d'un intégrateur 10 qui donne en sortie le s(t) dont la courbe est représentée sur le côté gauche de la figure. On distingue la présence de pic pendant le front montant et le front descendant du signal d'excitation. Pour éliminer ces pics, on va prendre la mesure, c'est-à-dire réaliser une démodulation synchrone uniquement pendant la durée où ces pics sont inexistants. On optimise en fait la fenêtre de prise en compte du signal de mesure : on ne garde que le signal utile. Pour ce faire, on génère, au moyen d'un générateur de signaux (non représenté), un signal f(t) qui varie entre 1 et O (et/ou -1) qui laisse passer le signal de mesure s(t) ou l'annule. Pour la démodulation synchrone, on utilise un amplificateur de gain 11, un démodulateur 12 et un filtre 13. Le signal f(t) est introduit soit au niveau du démodulateur soit au niveau du gain 11. La sortie du filtre donne une valeur proportionnelle à la capacité 3 : $K.C_{target}$.

On peut moduler tau afin de réduire ou éliminer complètement l'erreur en quadrature.

Bien sûr, l'invention n'est pas limitée aux exemples qui viennent d'être décrits et de nombreux aménagements peuvent être apportés à ces exemples sans sortir du cadre de l'invention.

**Revendications**

1. Procédé de mesure capacitive entre un objet (2) et un plan d'électrodes (1) effectué par une unité de traitement, comprenant :

   appliquer un signal d'excitation (U(t)) au plan d'électrodes (1), le signal d'excitation (U(t)) étant un signal non sinusoïdal ayant au moins une discontinuité ;
   recevoir un signal de mesure (s(t)) provenant du plan d'électrodes (1) ;
   atténuer le signal de mesure (s(t)) sur une fenêtre temporelle ($\tau$), cette fenêtre temporelle ($\tau$) étant la durée englobant la au moins une discontinuité ; et
   déterminer une valeur de capacité (3) à partir du signal de mesure (s(t)), quand le signal de mesure (s(t)) est non atténué.

2. Procédé selon la revendication 1, **caractérisé en ce que** le signal d'excitation (U(t)) comprend un signal carré ou rectangulaire.

3. Procédé selon la revendication 1, comprenant en outre déterminer la valeur de capacité (3) par démodulation (12) du signal de mesure (s(t)) non atténué.

4. Procédé selon la revendication 3, comprenant en outre démoduler le signal de mesure (s(t)) à l'extérieur de la fenêtre temporelle ($\tau$).

5. Procédé selon la revendication 1, comprenant en outre atténuer le signal de mesure (s(t)) en supprimant le signal de mesure (s(t)) sur ladite fenêtre temporelle ($\tau$).

6. Procédé selon la revendication 1, comprenant en outre identifier ladite fenêtre temporelle ($\tau$) en utilisant un signal de filtrage (f(t)).

7. Procédé selon la revendication 1, comprenant en outre garder le plan d'électrodes (1) en utilisant un plan de garde (G) active, le plan de garde (G) active recevant un signal de garde référencé au signal d'excitation (U(t)).

8. Appareil électronique de mesure capacitive entre un objet (2) et un plan d'électrodes (1), comprenant :

   une unité de traitement pour appliquer un signal d'excitation (U(t)) au plan d'électrodes (1) ; le signal d'excitation (U(t)) étant un signal non sinusoïdal ayant au moins une discontinuité ; et
   un circuit électronique couplé en communication à l'unité de traitement et configuré pour
   recevoir un signal de mesure (s(t)) provenant du plan d'électrodes (1) ; et
   atténuer le signal de mesure (s(t)) sur une fenêtre temporelle ($\tau$), cette fenêtre temporelle ($\tau$) étant la durée englobant la au moins une discontinuité ;
   l'unité de traitement est en outre capable de déterminer une valeur de capacité (3) à partir du signal de mesure (s(t)), quand le signal de mesure (s(t)) est non atténué.

9. Appareil électronique selon la revendication 8, **caractérisé en ce que** le signal d'excitation (U(t)) comprend un signal carré ou rectangulaire.

10. Appareil électronique selon la revendication 8, **caractérisé en ce que** le circuit électronique comprend un démodulateur (12) pour démoduler le signal de mesure (s(t)) non atténué.

11. Appareil électronique selon la revendication 10, **caractérisé en ce que** le démodulateur (12) est configuré pour démoduler le signal de mesure (s(t)) à l'extérieur de la fenêtre temporelle ($\tau$).

12. Appareil électronique selon la revendication 8, **caractérisé en ce que** le circuit électronique est configuré pour supprimer le signal de mesure (s(t)) sur ladite fenêtre temporelle ($\tau$).

13. Appareil électronique selon la revendication 8, **caractérisé en ce que** le circuit électronique est configuré pour recevoir un signal de filtrage (f(t)) pour identifier ladite fenêtre temporelle ($\tau$).

14. Appareil électronique selon la revendication 8, comprenant en outre un plan de garde (G) active situé à proximité du plan d'électrodes (1), le plan de garde (G) active recevant un signal de garde référencé au signal d'excitation (U(t)).

15. Appareil électronique selon la revendication 8, **caractérisé en ce que** le circuit électronique comprend en outre un intégrateur (10) ayant en entrée un courant (I(t)) alimentant ledit plan d'électrodes (1) pour recevoir le signal de mesure (s(t)) non atténué.

**Patentansprüche**

1. Kapazitives Messverfahren zwischen einem Objekt (2) und einer Elektrodenebene (1), welches von einer Verarbeitungseinheit durchgeführt wird, umfassend:

   Anwenden eines Anregungssignals (U(t)) auf die Elektrodenebene (1), wobei das Anregungssignal (U(t)) ein nicht-sinusförmiges Signal ist, welches zumindest eine Diskontinuität aufweist;
   Empfangen eines Messsignals (s(t)), welches von der Elektrodenebene (1) stammt;
   Abschwächen des Messsignals (s(t)), innerhalb eines Zeitfensters ($\tau$), wobei das Zeitfenster ($\tau$) die Zeitperiode ist, welche die zumindest eine Diskontinuität einschließt; und
   Bestimmen eines Kapazitätswerts (3) aus dem Messsignal (s(t)), wenn das Messsignal (s(t)) nicht abgeschwächt ist.

2. Verfahren nach Anspruch 1, wobei das Anregungssignal (U(t)) ein quadratisches Signal oder ein Rechtecksignal umfasst.

3. Verfahren nach Anspruch 1, ferner umfassend ein Bestimmen des Kapazitätswerts (3) durch Demodulieren (12) des nichtabgeschwächten Messsignals (s(t)).

4. Verfahren nach Anspruch 3, ferner umfassend ein Demodulieren des Messsignals (s(t)) außerhalb des Zeitfensters ($\tau$).

5. Verfahren nach Anspruch 1, ferner umfassend ein Abschwächen des Messsignals (s(t)) durch Unterdrücken des Messsignals (s(t)) innerhalb des Zeitfensters ($\tau$).

6. Verfahren nach Anspruch 1, ferner umfassend ein Identifizieren des Zeitfensters ($\tau$) unter Verwendung eines Filtersignals (f(t)).

7. Verfahren nach Anspruch 1, ferner umfassend Schützen der Elektrodenebene (1) durch Verwendung einer aktiven Schutzebene (G), wobei die aktive Schutzebene (G) ein Schutzsignal empfängt, welches auf das Anregungssignal (U(t)) referenziert ist.

8. Elektronische Vorrichtung zum kapazitiven Messen zwischen einem Objekt (2) und einer Elektrodenebene (1), umfassend:

   eine Verarbeitungseinheit, die eingerichtet ist zum Anwenden eines Anregungssignals (U(t)) auf die Elektrodenebene (1), wobei das Anregungssignal (U(t)) ein nicht-sinusförmiges Signal ist, welches zumindest eine Diskontinuität aufweist; und

eine elektronische Schaltung, welche kommunikativ mit der Verarbeitungseinheit gekoppelt ist und eingerichtet ist zum

Empfangen eines Messsignals (s(t)), welches von der Elektrodenebene (1) stammt, und

Abschwächen des Messsignals (s(t)) innerhalb eines Zeitfensters ($\tau$), wobei das Zeitfenster ($\tau$) die Zeitperiode ist, welche die zumindest eine Diskontinuität einschließt;

wobei die Verarbeitungseinheit ferner in der Lage ist, ein Kapazitätswert (3) aus dem Messsignal (s(t)) zu bestimmen, wenn das Messsignal (s(t)) nicht abgeschwächt ist.

9.  Elektronische Vorrichtung nach Anspruch 8, wobei das Anregungssignal (U(t)) ein quadratisches Signal oder ein Rechtecksignal ist.

10. Elektronische Vorrichtung nach Anspruch 8, wobei die elektronische Schaltung einen Demodulator (12) umfasst zum Demodulieren des nichtabgeschwächten Messsignals (s(t)).

11. Elektronische Vorrichtung nach Anspruch 10, wobei der Demodulator (12) eingerichtet ist zum Demodulieren des Messsignals (s(t)) außerhalb des Zeitfensters ($\tau$).

12. Elektronische Vorrichtung nach Anspruch 8, wobei die elektronische Schaltung eingerichtet ist zum Unterdrücken des Messsignals (s(t)) innerhalb des Zeitfensters ($\tau$).

13. Elektronische Vorrichtung nach Anspruch 8, wobei die elektronische Schaltung eingerichtet ist zum Empfangen eines Filtersignals (f(t)) zum Identifizieren des Zeitfensters ($\tau$).

14. Elektronische Vorrichtung nach Anspruch 8, ferner umfassend eine aktive Schutzebene (G), die in der Umgebung der Elektrodenebene (1) gelegen ist, wobei die aktive Schutzebene (G) ein Schutzsignal empfängt, welches auf das Anregungssignal (U(t)) referenziert ist.

15. Elektronische Vorrichtung nach Anspruch 8, wobei die elektronische Schaltung ferner einen Integrator (10) umfasst, der als Eingabe einen Strom (I(t)) hat, der die Elektrodenebene (1) speist zum Empfangen des nichtabgeschwächten Messsignals (s(t)).

**Claims**

1.  A method of capacitive measurement between an object (2) and an electrode plane (1) performed by a processor unit, comprising:

    applying an excitation signal (U(t)) to the electrode plane (1), the excitation signal (U(t)) being a non-sinusoidal signal having at least one discontinuity;
    receiving a measurement signal (s(t)) originating from the electrode plane (1);
    attenuating the measurement signal (s(t)) within a temporal window ($\tau$), the temporal window ($\tau$) being the time period encompassing the at least one discontinuity; and
    determining a capacitance value (3) from the measurement signal (s(t)) when the measurement signal (s(t)) is unattenuated.

2.  The method of claim 1, the excitation signal (U(t)) comprising a square or rectangular signal.

3.  The method of claim 1, further comprising determining the capacitance value (3) by demodulating (12) the unattenuated measurement signal (s(t)).

4.  The method of claim 3, further comprising demodulating the measurement signal (s(t)) outside the temporal window ($\tau$).

5.  The method of claim 1, further comprising attenuating the measurement signal (s(t)) by suppressing the measurement signal (s(t)) within the temporal window ($\tau$).

6.  The method of claim 1, further comprising identifying the temporal window ($\tau$) using a filtering signal (f(t)).

7. The method of claim 1, further comprising guarding the electrode plane (1) using an active guard plane (G), the active guard plane (G) receiving a guard signal referenced to the excitation signal (U(t)).

8. An electronic device for capacitive measurement between an object (2) and an electrode plane (1), comprising:

a processing unit capable of applying an excitation signal (U(t)) to the electrode plane (1); the excitation signal (U(t)) being a non-sinusoidal signal having at least one discontinuity; and
an electronic circuit communicatively coupled to the processing unit and configured for
receiving a measurement signal (s(t)) originating from the electrode plane (1), and
attenuating the measurement signal (s(t)) within a temporal window ($\tau$), the temporal window ($\tau$) being the time period encompassing the at least one discontinuity;
wherein the processor unit is further capable of determining a capacitance value (3) from the measurement signal (s(t)) when the measurement signal (s(t)) is unattenuated.

9. The electronic device of claim 8, wherein the excitation signal (U(t)) is a square or rectangular signal.

10. The electronic device of claim 8, wherein the electronic circuit comprises a demodulator (12) for demodulating the unattenuated measurement signal (s(t)).

11. The electronic device of claim 10, wherein the demodulator (12) is configured for demodulating the measurement signal (s(t)) outside the temporal window ($\tau$).

12. The electronic device of claim 8, wherein the electronic circuit is configured for suppressing the measurement signal (s(t)) within the temporal window ($\tau$).

13. The electronic device of claim 8, wherein the electronic circuit is configured for receiving a filtering signal (f(t)) for identifying the temporal window ($\tau$).

14. The electronic device of claim 8, further comprising an active guard plane (G) located in proximity to the electrode plane (1), the active guard plane (G) receiving a guard signal referenced to the excitation signal (U(t)).

15. The electronic device of claim 8, **characterized in that** the electronic circuit further comprising an integrator (10) having as an input a current (I(t)) supplied to the electrode plane (1) for receiving the unattenuated measurement signal (s(t)).

FIG. 1a

FIG. 1b

FIG. 2

FIG. 3a                    FIG. 3b                    FIG. 3c

R2=100,C1=C2=100pF,R1=1Ω to 10KΩ};
$C_{target}$ =1fF

$C(j\omega)$- $C_{target}$

Capacité équivalente (en pF) donnant la
même impédance que 1/R(jω)

**FIG. 4**

**FIG. 5a**

Transition Tau

$$\int_0^{Tau} i(t)dt = C_{target}U_{max}$$

$$\int_0^{Tau} i_1(t)dt = 0 \text{ car } C_1 \text{ est déchargé avant et après la transition}$$

Donc : $\int_0^{Tau} I(t)dt = \int_0^{Tau}(i(t)+i_1(t))dt = C_{target}U_{max}$

**FIG. 5b**

FIG. 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2756048
- FR 2893711
- FR 2844349
- US 5651044 A
- US 4634964 A
- US 3761805 A